# EUROPEAN PATENT APPLICATION

(11) **EP 2 811 515 A1**
(43) Date of publication of application: **10.12.2014**
(21) Application number: 13290127.3
(22) Date of filing: 07.06.2013
(51) Int. Cl.: H01L 23/40

(54) **Thermal connector and heat distribution device for a thermal connector**

(71) Applicant: ALCATEL LUCENT, 92100 Boulogne-Billancourt (FR)
(72) Inventor: Goetz, Hans-Joachim, 90411 Nuernberg (DE); Haberditzl, Rainer, 90411 Nuernberg (DE); Seitz, Reinhold, 90411 Nuernberg (DE)
(74) Representative: DREISS Patentanwälte PartG mbB

(57) **Abstract**

The invention relates to a thermal connector (100) for establishing a thermally conductive connection with at least a first element (200), wherein said thermal connector (100) comprises a first contact surface (110) for contacting a portion of said first element (200), wherein said first contact surface (110) at least partly comprises a conical shape.

## Description

### Field of the invention

The present invention relates to a thermal connector for establishing a thermally conductive connection with at least a first element. The present invention further relates to a heat distribution device for establishing a thermally conductive connection with at least one element.

### Background

Prior art thermal connectors usually are difficult to mount in order to ensure a good thermal coupling to a further element heat energy is to be transferred to. Moreover, the size required for conventional thermal connectors prevents these prior art connectors from being applied to highly integrated electric devices.

### summary

In view of this, it is an object of the present invention to improve a thermal connector of the aforementioned type to overcome the disadvantages of prior art.

Regarding the thermal connector, this object is achieved by said thermal connector comprising a first contact surface for contacting a portion of said first element, wherein said first contact surface at least partly comprises a conical shape. The conical shape advantageously enables a simplified mounting of the thermal connector at the first element or any suitable target system and, at the same time, offers a comparatively large thermal contact surface by means of the conical shape. Especially, the thermal connector according to the embodiments has a comparatively small footprint due to utilizing the conical shape for heat transfer, thus avoiding the requirement of large two-dimensional contact areas as given by prior art thermal connectors.

According to a preferred embodiment said connector comprises a basically cylindrical main body, wherein said conical shape of said contact surface extends along an axial direction of said main body. Thus, a particularly small cross-section can be attained.

According to one embodiment, in addition to the conically shaped first contact surface of the connector, a radially outer surface of the basically cylindrical main body may also be used for establishing thermally conductive contact surfaces.

According to a further embodiment, it is also possible to provide the conductor with more than one conical contact surface for heat transfer.

According to a further configuration, it is also possible to provide a main body in form of a hollow cylinder, which may have a circular or differently shaped cross-section, i. e., a polygonal cross-section or the like.

When providing a polygonal cross-section for the main body, advantageously, plain contact surfaces at the radially outer side of the main body are attained to which heat sources such as e.g. power semiconductors and the like may advantageously be directly attached for heat transfer to the thermal connector. Heat energy received from these devices at the main body region of the thermal connector may advantageously be forwarded by means of heat conduction to the first contact surface with its conical shape for transfer to a heat sink to which the thermal connector may be attached.

According to a further preferred embodiment said connector comprises at least one threaded hole. This advantageously facilitates mounting the thermal connector at a target system, e.g. at a heat sink or the like. For example, a corresponding mounting hole may be provided at the heat sink, and a threaded bolt may be provided by means of which the thermal connector according to an embodiment may be fixedly attached to the heat sink. The threaded bolt advantageously secures the thermal connector in its mounting position at the heat sink and thus also ensures an efficient thermal conductivity between the thermal connector and the heat sink.

According to a further embodiment, advantageously, an active jack screw may be used in combination with a threaded hole of the thermal connector for attaching said thermal connector to the target system.

According to a further embodiment, the threaded bolt / active jack-screw may even be used for pushing out the thermal connector of its mounting position at the target system if it is seated too tight, which depends on an angle of the conical section of first contact surface.

According to a further preferred embodiment said connector comprises at least one further contact surface for establishing a thermally conductive connection with at least one second element. Thus, the thermal connector may advantageously be used to link the first element and the second element with each other in a thermally conductive fashion. For example, the first element may represent or comprise, respectively, a heat source, and the thermal connector may be used to establish a thermally conductive connection to the second element, which may be a heat sink according to the present example. Of course, the first element may also represent a heat sink, and the second element may represent a heat source or comprise a heat source, respectively.

According to a further embodiment, it is also possible to establish a daisy-chained configuration of heat sources and / or heat sinks by using one or more thermal conductors according to the embodiments. Thereby, an efficient heat transfer between various elements or devices is enabled, wherein the thermal connector according to the embodiments advantageously enables an easy mounting and removal of the thermal connector to or from the target systems. Especially, the mounting or removing of the thermal connector with respect to the target system may easily be done even under difficult conditions, i.e., in the field, e.g., by a service technician, because the conical shape of the first contact surface provides suitable guidance when inserting the thermal connector to a corresponding mating surface.

According to a further preferred embodiment at least one of said contact surfaces at least partially comprises a surface finish with a surface roughness Ra of about 10 µm or less, and/or a microstructured surface, and/or a polished surface, and/or thermally conductive material (e.g., copper material, and/or aluminum) or any other highly thermally conductive material such as silver or alloys thereof. These measures alone or in combination advantageously contribute to a low thermal resistance of the thermal connector according to the embodiments.

According to a further preferred embodiment said connector comprises a heat transfer device for establishing a thermally conductive connection with at least one second element. According to this embodiment, it is not required to provide a heat source directly at e.g. the main body of the thermal connector. Rather, the heat transfer device may advantageously be used to provide heat energy from the thermal connector to a remote location or vice versa.

According to a particularly preferred embodiment, said heat transfer device comprises at least one heat pipe. According to a further preferred embodiment, said heat pipe comprises at least one flexible section, which advantageously further facilitates easy mounting of the thermal connector to a target system such as the heat sink.

According to a further embodiment, advantageously, a thermal connector may e.g. be attached to a pluggable unit such as a line card or printed circuit board in general so that when the line card is inserted into a backplane system, the thermal connector can establish a thermally conductive connection to a heat sink by means of its first contact surface. On the other hand, the thermal connector may efficiently be connected to a heat source located on, e. g., the line card so that an efficient heat transfer is achieved from the heat source via the heat pipe, the thermal connector and to the heat sink. Thereby, an efficient way of cooling heat sources such as power semiconductors comprised on line cards and printed circuit boards is attained while not losing the advantages of detachable attachment of the line card to target system such as a backplane arrangement.

According to a further preferred embodiment said connector comprises a mounting unit for detachably attaching said connector to a target system. This advantageously enables to flexibly add or remove one or more thermal connectors to/from the target system.

According to an advantageous embodiment, the mounting unit may comprise an assembly bracket which allows for one, two or three-dimensional movement of the thermal connector with respect to, e. g., a pluggable unit such as a line card the thermal connector is associated with. Thereby, tolerances between the line card and its target system may be compensated while at the same time ensuring an optimized mating between the first contact surface of the thermal connector and the corresponding contact surface of the target system, i.e. a heat sink.

The mounting unit may also comprise a spring arrangement which provides a retention force that keeps the thermally active contact surface of the thermal connector in place in its mounting position.

A further solution to the object of the present invention is given by a pluggable electric device comprising at least one thermal connector according to the embodiments. The pluggable electrical device may e.g. be a line card, which may be inserted into a backplane or some other type of circuit board capable of receiving one or more line cards.

According to a further embodiment, the pluggable electrical device may also comprise processor modules or hard-disc modules for personal computers or main frames or the like, where efficient cooling is required and advantageously enabled by providing at least one thermal connector according to the embodiments.

According to a preferred embodiment of the pluggable electric device, said at least one thermal connector is arranged at an edge section of said device to facilitate the insertion of the thermal connector in a corresponding receptacle of the target system, e. g., heat sink, when inserting the pluggable electrical device into said target system. In other words, the thermal connector according to the embodiments may be mounted in a similar fashion as conventional optical and / or electrical connectors on said line card.

According to a further embodiment, said at least one thermal connector is movably attached to said device or a component thereof, whereby tolerances between the pluggable electrical device and a target system receiving and said pluggable electrical device can be compensated.

A further solution to the object of the present invention is given by a pluggable device comprising at least one thermal connector according to the embodiments. I.e., according to this embodiment, the device equipped with at least one thermal connector according to the embodiments is not required to comprise electrical components. Rather, the device may comprise any element which may require temperature control such as e.g. cooling or heating. For example, the device may comprise hydraulic or optic components cooling of which is facilitated by the thermal connector according to the embodiments.

A further solution to the object of the present invention is given by a heat distribution device for establishing a thermally conductive connection with at least one element, particularly with at least one thermal connector according to the embodiments, wherein said heat distribution device comprises at least one contact surface for contacting said element, and said at least one contact surface at least partly comprises a conical shape. The heat distribution device according to the embodiments advantageously enables to receive at least one thermal connector, preferably according to the embodiments, whereby efficient heat transfer between the thermal connector and the heat distribution device is enabled.

According to an advantageous embodiment, the heat distribution device comprises attaching means for detachably attaching said at least one element to said device. The attaching means may e.g. comprise a through-hole combined with a threaded bolt and may be used to attach the thermal connector to the heat distribution device if the thermal connector comprises a corresponding threaded hole for receiving the screw or bolt.

According to a further advantageous embodiment, the heat distribution device may also comprise further heat transfer units such as cooling channels a cooling fluid may flow through, cooling fins or even active cooling devices such as Peltier elements or the like.

### Brief description of the Figures

Further features, aspects and advantages of the present invention are given in the following detailed description with reference to the drawings in which:
- Figure 1a: schematically depicts a perspective view of a thermal connector according to an embodiment,
- Figure 1b: schematically depicts a partial cross-sectional view of a thermal connector according to the embodiments in a mounting position,
- Figure 2: schematically depicts a side view of a thermal connector according to a further embodiment,
- Figure 3: schematically depicts a side view of a thermal connector according to a further embodiment with a mounted heat source,
- Figure 4: schematically depicts a front view of a thermal connector according to a further embodiment with mounted heat sources on radially outer surfaces of the thermal connector,
- Figure 5: schematically depicts a side view of a thermal connector according to a further embodiment,
- Figure 6: schematically depicts a side view of a thermal connector according to a further embodiment, wherein a heat source is connected to the thermal connector by means of a heat pipe,
- Figure 7: schematically depicts a thermal connector according to a further embodiment,
- Figure 8: schematically depicts a thermal connector according to a further embodiment,
- Figure 9: schematically depicts a thermal connector associated with a pluggable electrical device according to an embodiment,
- Figure 10: schematically depicts a partial cross-section of a heat distributing device according to an embodiment,
- Figure 11: schematically depicts a partial cross-section of a heat distributing device according to a further embodiment with thermal connectors according to the embodiments inserted therein,
- Figure 12: schematically depicts a front view of a plurality of the pluggable electrical devices according to an embodiment, and
- Figure 13: schematically depicts a thermal connector according to a further embodiment.

### Description of the embodiments

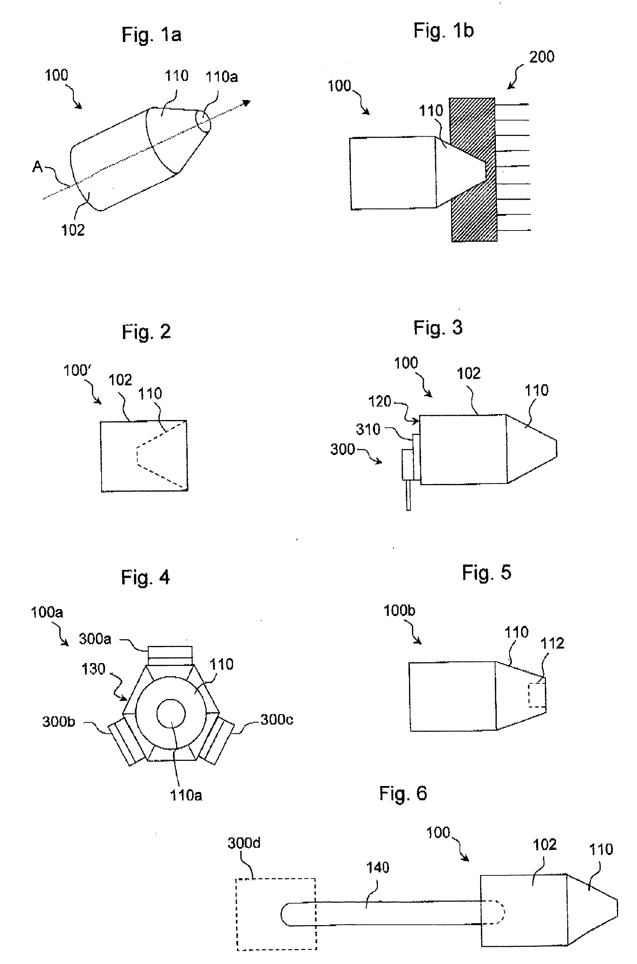

Figure 1 schematically depicts a perspective view of a thermal connector 100 according to an embodiment. The thermal connector 100 comprises a basically cylindrical main body 102 a longitudinal axis of which is depicted in Figure 1a by a dotted arrow A. The thermal connector 100 comprises a first contact surface 110 which at least partly comprises a conical shape. More precisely, to implement the conically shaped first contact surface 110, according to the present embodiment, the thermal connector 100 comprises a conical portion also extending along the longitudinal axis A as depicted by Figure 1a. According to the present embodiment, the conical portion with its base surface contacts the cylindrically shaped main body 102. A top surface of the conical portion is denoted by reference sign 110a.

Generally, the first contact surface 110 with the conical shape may comprise a frustum (also referred to as "truncated cone") having nonvanishing base and top radii, or a full cone with a vanishing top radius.

According to a preferred embodiment, both the main body 102 and the conical section comprising the first contact surface 110 are made from the same material, most preferably as a monolithic component.

According to a preferred embodiment, the thermal connector 100 is made of a highly thermally conductive material or at least comprises such material. Examples are, e.g., copper, aluminium, silver, or alloys thereof.

Figure 1b depicts a side view of a thermal conductor 100 according to an embodiment in its mounting position with respect to a heat sink 200. As can be seen from Figure 1b, the heat sink 200 comprises a conically shaped receiving section the first contact surface 110 of the thermal connector 100 can at least partly be inserted into.

Advantageously, the effective contact surface between the components 100, 200 is comparatively large although a footprint (cross-sectional area required by thermal connector 100 in a plane perpendicular to the longitudinal axis A of Figure 1a) is comparatively small.

Thus, the thermal connector 100 can efficiently transfer heat energy from its main body 102 or its contact surface 110 to the heat sink 200 or vice versa.

According to a further embodiment 100', a schematic side view of which is depicted by Figure 2, a conical contact surface 110 can also be implemented in the form of a conically shaped cavity in the main body of the thermal connector 100'. This embodiment also facilitates efficient heat energy transfer to an external device due to the comparatively large surface 110 which is attained by the conical form. Thus, according to some embodiments, the conical first contact surface 110 may be a concave conical surface (Fig. 2), and according to some other embodiments, the conical first contact surface 110 may be a convex conical surface.

Figure 3 depicts a side view of a thermal connector 100 according to an embodiment with a heat source 300 attached directly to a main body 102 of the thermal connector 100.

According to this embodiment, a heat source 300 in the form of a power semiconductor is provided. A cooling fin 310 of the power semiconductor 300 is directly attached to a rear surface 120 of the main body 102 of the thermal connector 100, thus providing an efficient heat transfer from the heat source 300 to the thermal connector 100. In turn, the first contact surface 110 of the thermal connector 100 provides an efficient heat transfer to a heat sink 200 (Figure 1b). Particularly, the first contact surface 110 due to its conical shape advantageously offers a comparatively large thermally conductive heat transfer surface for heat transfer to a heat sink 200, as compared to the comparatively small contact surface between the cooling fin 310 and the main body 102 or its rear surface 120 of the thermal connector 100. Thus, a reliable cooling of the power semiconductor 300 is enabled when the thermal connector 100 is mounted to a heat sink 200.

Figure 4 depicts a front view of a thermal connector 100a according to a further embodiment. Presently, the main body of the thermal connector 100a comprises a hexagonal shape, wherein three surface segments 130 of the main body comprise semiconductors 300a, 300b, 300c as heat sources attached to the thermal connector 100a. Heat dissipated by these heat sources 300a, 300, 300c and transferred to the main body of the thermal connector 100a can be further transferred to a heat sink 200 (Figure 1b) by means of the first contact surface 110, which again comprises a conical shape as depicted by Figure 4. As can be seen from Figure 4, the polygonal shaped main body enables an efficient direct attachment of heat sources to the main body of the thermal connector 100a.

According to a further embodiment, instead of a hexagonal shape as depicted by Fig. 4, other geometries are possible which comprise e.g. two or more flattened surface areas according to a number of semiconductors (or other heat sources) to be attached.

Figure 5 shows a simplified side view of a thermal connector 100b according to a further embodiment. In contrast to the thermal connector 100 and according to Figure 1a, the embodiment 100b according to Figure 5 comprises a threaded hole 112 in the conically shaped potion of the thermal connector 100b. Thus, the thermal connector 100b may be easily mounted by using a threaded bolt, e. g., to a heat sink 200 comprising a through-hole for receiving the threaded bolt.

Other types of mounting of the thermal connector 100b to a heat sink or another target system are also possible, i. e., providing a threaded section (not shown) on the radially outer section of the main body of the thermal connector 100b or a clamping mechanism or the like.

Figure 6 depicts a further embodiment, wherein the thermal connector 100 comprises a heat pipe 140 as heat transfer means for transferring heat from a remote device 300d, i.e., again a semiconductor-based heat source, to the main body 102 of the thermal connector 100.

Preferably, the heat pipe 140 is fixedly attached to the main body 102, thus enabling an efficient transfer of heat energy from the heat pipe 140 to the thermal connector 100. The "hot end" of the heat pipe 140 is attached to the heat source 300d, e. g., by using conventional means. When attaching the thermal connector 100 as depicted by Figure 6 to an appropriate heat sink 200 (Figure 1b), an efficient cooling of the semiconductor heat source 300d is possible. Due to the conical shape of the first contact surface 110, an easy mounting, which also facilitates an efficient detachment of the thermal connector 100 from the heat sink 200, i. e., for service purposes or the like, is also enabled, which cannot be obtained with conventional mounting systems.

At the same time, an efficient transfer of heat energy through the thermal connector 100 to the heat sink 200 is given without requiring a comparatively large footprint area perpendicular to the longitudinal axis A (Figure 1a) of the thermal connector 100.

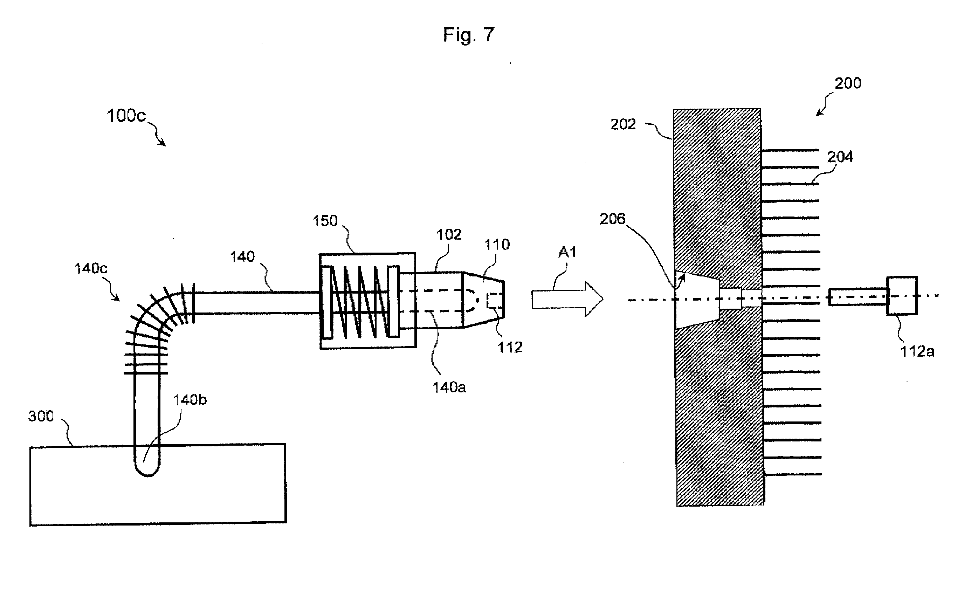

Figure 7 depicts a thermal connector 100c according to a further embodiment in a typical operational scenario. Also depicted by Figure 7 is a heat distribution device 200, particularly heat sink, according to an embodiment.

As already explained above, the thermal connector 100c comprises a basically cylindrically shaped main body 102 and a conical section, which implements the conical first contact surface 110. The thermal connector 100c according to Figure 7 also comprises a threaded hole 112 in its conical section, which can work together with a threaded bolt 112a for securely attaching the thermal connector 110c to the heat sink 200. For this purpose, the heat sink 200 has a through-hole extending beyond the conically shaped reception area, wherein a conical surface 206 is provided in the heat sink 200 for mating contact with the first contact surface 110 of the thermal connector 100c.

I. e., when introducing the thermal connector 100c into the heat sink 200 in the direction depicted by block arrow A1, the contact surfaces 110, 206 will make contact with each other and thus, provide a comparatively large heat transfer surface between the components 100c, 200, thus efficiently enabling a removal of heat energy from the thermal connector 100c to the heat sink 200. Also, in the mounting position, the threaded bolt 112a may be used as already explained above to secure the thermal connector 100c to the heat sink 200.

The main body 202 of the heat sink may be made of a thermally conductive material such as aluminium or copper or silver or alloys thereof or the like, and cooling fins 204 may be provided to enable a per se known convection cooling or forced air cooling or the like.

Alternatively or in addition, cooling channels (not depicted) may also be comprised in the main body 202 of the heat sink 200.

According to a further embodiment, the heat sink 200 may also comprise more than one conical reception area for receiving a plurality of thermal connectors 100c according to the embodiments.

The thermal connector 100c according to Figure 7 comprises a heat transfer device 140 in the form of a heat pipe. In contrast to the heat pipe depicted by Figure 6, presently, the heat pipe 140 comprises a flexible section 140c between a first end portion 140a and a second end portion 140b. Thus, a mechanically very flexible solution is offered for attaching the heat source 300 in a thermally conductive manner to the thermal connector 100c. The first end portion 140a, also referred to as "cold end" of the heat pipe 140, is integrated into the main body 102 and / or at least partly into the conical section comprising the first contact surface 110 of the thermal connector 100c, thus providing an efficient heat transfer from the heat pipe 140 to the thermal connector 100c or its main body 102 and/or the first contact surface 110, respectively.

The second end section 140b of the heat pipe 140 is attached to the heat source 300, also in a thermally conductive manner, wherein conventional techniques may be used. By providing the flexible section 140c, further degrees of freedom when mounting the thermal connector 100c to the heat sink 200 may be achieved. Usually, if the heat source 300 comprises semiconductors, these semiconductors are attached to a printed circuit board or some other fixed component. Providing the flexible section 140c of the heat pipe 140 advantageously enables to compensate mounting or positioning tolerances between components 200, 300 when introducing the thermal connector 100c to the heat sink 200, thus still enabling a precise mating of the important thermally conductive contact surfaces 110, 206 of the components 100c, 200.

Optionally, the thermal connector 100c may comprise a mounting unit 150, which may comprise an assembly bracket that allows mechanical attachment of the main body 102 to attachment means (not shown in Figure 7). Preferably, the mounting means 150 enable a one- or more-dimensional relative movement of the main body 102 and its contact surface 110 with respect to a mounting frame of the mounting unit 150, thus also enabling to compensate for positioning or manufacturing tolerances.

Spring means may also be provided in the mounting unit 150, which advantageously enable an axial displacement or movement of the thermal connector 100c in a direction corresponding to a horizontal direction of Figure 7.

Thus, even in the absence of a threaded bolt connection 112, 112a, a minimum mating force between contact surfaces 110, 206 can be guaranteed by the spring means of the mounting unit 150.

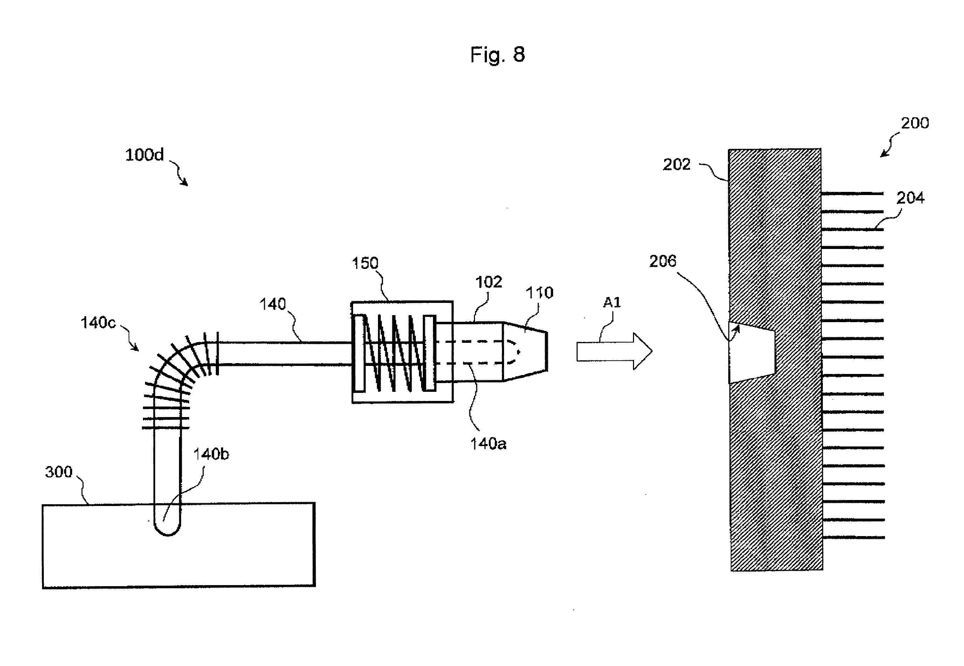

Figure 8 depicts a further embodiment 100d of a thermal connector. In contrast to the embodiment of Figure 7, the thermal connector 100d of Figure 8 does not comprise a threaded hole. Rather, spring means are integrated in the mounting unit 150, establishing a corresponding mating force (acting in a horizontal direction of Figure 7) between contact surfaces 110, 206 for efficient heat transfer between the components 100d, 200. Correspondingly, the heat sink 200 of Figure 8 is not required to comprise a through-hole, which allows insertion of a threaded bolt 112a as depicted by Figure 7.

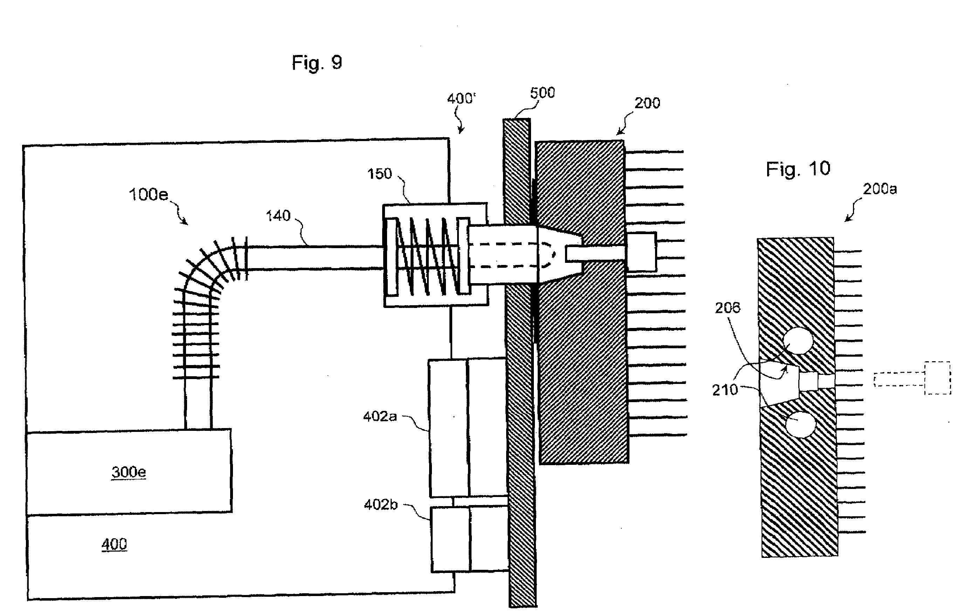

Figure 9 depicts a side view of a thermal connector 100e according to a further embodiment.

Presently, the thermal connector 100e is attached to a pluggable electrical unit 400, which may be a printed circuit board or a line card or some other form of extension card for an electrical system such as a computer system or the like. The pluggable device 400 comprises electrical and / or optical connectors 402a, 402b, which may be inserted into corresponding sockets provided on a backplane 500, wherein said backplane 500 may be configured to comprise a comparatively large number of corresponding sockets or receiving a plurality of pluggable devices 400 as depicted by Figure 9.

Attached to the pluggable device 400 is a thermal connector 100e, which comprises a flexible heat pipe 140 comprising at least one flexible section 140c as explained above. The thermal connector 100e is attached to the body of the pluggable electrical device 400 by means of a mounting unit 150. A heat source 300e, which again may comprise one or more semiconductors or the like, is also arranged on the pluggable electrical device 400. For example, the heat source 300e may comprise high power semiconductors such as power amplifiers or a central processing unit or the like.

The heat pipe 140 efficiently transfers heat energy provided by the heat source 300e to the main body 102 (Fig. 1a) and the first, conically shaped, contact surface 110 of the thermal connector 100e (Fig. 9). Presently, as the pluggable device 400 is plugged into the backplane 500, the thermal connector 100e with its first contact surface is also inserted in a heat sink 200 provided on a rear side of the backplane 500. For this purpose, the backplane 500 comprises an opening which enables to feed through the conical surface and / or a portion of a main body of the thermal connector 100e so that the conical contact surface of the thermal connector 100e can be secured to the heat sink 200 by means of the threaded bolt. In other words, according to the operational scenario depicted by Figure 9, the pluggable electrical device 400 is connected to the backplane 500 in an electrical and / or optical fashion by means of the connectors 4402a, 402b, and is also connected in a thermally conductive manner to the heat sink 200 by means of the thermal connector 100e.

It is evident that the thermal connector 100e according to the embodiments advantageously enables an efficient establishing of a thermally conductive connection between the line card 400 and the heat sink 200, which connection may also easily be attached or detached in the field.

The conical shape of the first contact surface 110 enables an efficient mechanical connection and good contact surface mating between components 100e, 200, and, at the same time, requires a comparatively small footprint so that the opening required in the backplane 500 for feeding through the thermal connector 100e or its main body, respectively, does not have to exceed typical area ranges as known from slot widths provided with conventional backplane systems.

Figure 10 depicts a heat sink 200a according to a further embodiment. The heat sink comprises at least one conical contact surface 206 for receiving a thermal connector according to the embodiments. Optionally, a threaded bolt may be provided for securing a thermal connector (not shown) to the heat sink 200a. In addition to the cooling fins, cooling channels 210 may be provided for guiding a cooling fluid through the main body of the heat sink 200a.

According to a further embodiment, element 200a is not required to form a dedicated heat sink. It is also possible that element 200a is a part of a mechanical structure such as e.g. a housing or the like. I.e., the function of the heat distribution device 200a according to the embodiments may also be implemented by regular device housings and the like as long as a contact surface according to the embodiments is present.

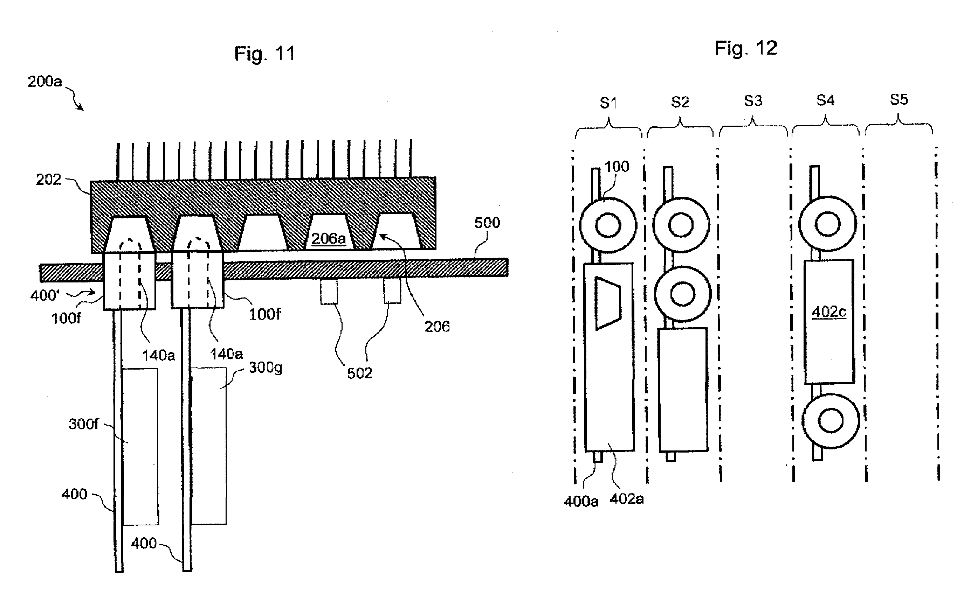

Figure 11 depicts a top view of a line card arrangement, wherein two line cards 400 are inserted to a backplane 500 and their corresponding thermal connectors 100f are inserted in corresponding receiving contact surfaces 206a that are provided in a heat sink 200a.

In a first slot (not depicted), a first line card 400 is provided, which comprises a heat source 300f, which may e.g. be a central processing unit. The heat source 300f is connected to the thermal connector 100f of the first line card by means of a heat pipe, only a cool end of which is indicated by the dashed lines 140a. The remaining parts of the heat pipe are not depicted in Figure 11 for the sake of clarity. The heat pipe enables a heat transfer form the heat source 300f to the thermal connector 100f of the first line card.

Likewise, heat transfer from a second heat source 300g comprised on a second line card 400 to the thermal connector 100f of the second line card is provided.

An electrical connection between components of the line cards 400 and the backplane 500 is established by electrical connectors and sockets, both of which are not shown for the depicted line cards 400 in Fig. 11 for the sake of clarity. However, two further empty slots of the backplane 500 can be seen from Figure 11, the sockets 502 of which are depicted in Figure 11.

In total, the arrangement of Figure 11 comprises a heat sink with five conically shaped receiving sections, each of which comprises a conically shaped contact surface 206 for establishing thermally conductive contact with the corresponding first contact surface 110 of the thermal connector 100f. Thus, by plugging the line cards 400 into the backplane 500, an electrical and / or optical connection between the line card 400 and the backplane 500 is established. At the same time, by introducing the respective thermal connector 100f of the respective line card 400 into the heat sink 200a, a thermally conductive connection between the respective line card or its heat source 300f, 300g and the common heat sink 200a is also established. In other words, by employing the thermal connectors 100f according to the embodiments, a "plug-and-play"-type solution for removal of heat energy from the line cards 400 to a heat sink 200a associated with a backplane 500 is enabled.

To ensure full mating between the contact surfaces 110, 206 of the components 100f, 202, the conically shaped receiving sections 206a of the heat sink 200a may also be extended by a further cylindrical section further extending into the main body 202 of the heat sink, thus ensuring that full mating between the conically shaped contact surfaces 206, 110 is attained, i.e. to avoid that a top section 110a (Fig. 1a) of the connector 100f makes contact with the main body 202 thus preventing proper insertion of the connector 100f to the heat sink 200a.

According to a further embodiment, an EMC (electromagnetic compatibility) gasket may be provided on either side of the backplane 500, preferably around the opening required in the backplane 500 for guiding the thermal conductor 100f into the heat sink 200a, to prevent electromagnetic radiation from leaking through the opening.

According to a further embodiment, in addition to providing a thermally conductive connection, the main body 102 and/or the first contact surface 110 of the thermal connector 100 (Fig. 1) may also be used for establishing an electrically conductive connection, e.g. between an electrical ground potential terminal of the line card 400 (Figure 11) and an electric ground potential defined by the heat sink 200a. This is particularly beneficial in the case of securing the thermal connector 100f to the heat sink 200a by means of a threaded bolt or some kind of a clamping mechanism or the like, because in this case, a reliable highly electrically conductive connection may be provided in addition to the thermal connection by the thermal connector.

Figure 12 depicts a front view of a plurality of pluggable electrical devices according to an embodiment inserted into various slots S1, S2, .., S5 of a backplane system.

Only a first line card is explicitly designated by the reference numeral 400a for the sake of clarity. The line card 400a is inserted into the first slot S1 and comprises an electrical connector 402a, which may be inserted into a corresponding socket 502 (Figure 11) of a backplane. Likewise, a thermal connector 100 according to the embodiments is provided on the line card 400a. As can be seen, the thermal connector 100, which is aligned with its longitudinal axis A (Fig. 1) perpendicular to the drawing plane of Fig. 11, comprises a comparatively small footprint, thus also fitting into the slot width of the first slot S1. However, due to utilizing a conically first contact surface 110 (Fig. 1) for thermal conduction, a comparatively large thermally active surface is attained as compared to mere two-dimensional contact surfaces provided by conventional thermal connectors. In other words, when providing a conically shaped first contact surface 110, a basic cone of which has a height of 10 mm, a major radius of 22 mm and a minor radius of 18 mm, an effective contact surface for thermal conduction of about 13.56 square centimetres can be attained, which corresponds to a two-dimensional contact surface of rectangular shape of length of about 61.5 mm and width of about 22 mm, which obviously is rather disadvantageous when provided for line card purposes due to the restricted slot area.

A second slot S2 as depicted by Figure 12 comprises a further line card, which also comprises an electrical connector, and which, in contrast to the first line card 400a, comprises two thermal connectors according to the embodiments.

Slots S3, S5 as depicted by Figure 12 are empty, and slot S4 comprises a further line card, an electrical connector 402c of which is arranged between two thermal connectors according to the embodiments.

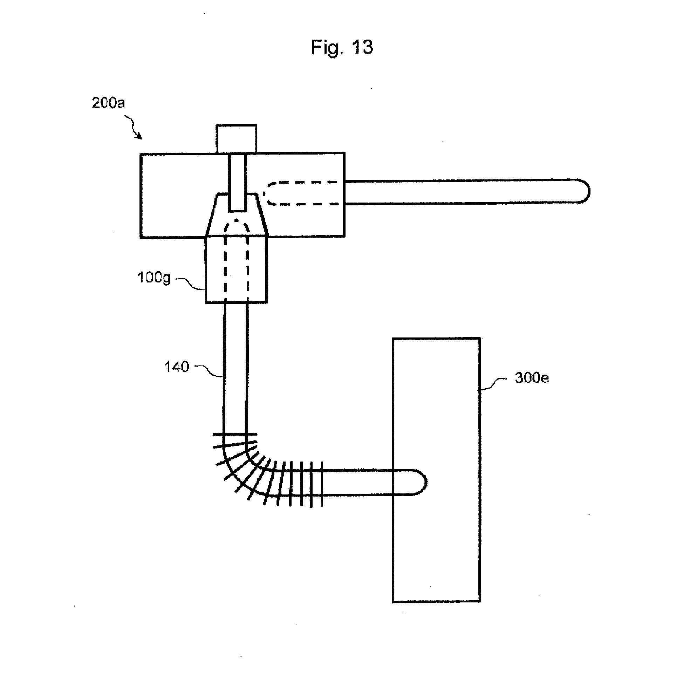

Figure 13 depicts a further embodiment 100g of a thermal connector 100g. A flexible heat pipe 140 of the thermal connector 100g is connected to a first heat source 300e, thus enabling heat energy transfer from the first heat source 300e to the thermal connector 100g. The thermal connector 100g is attached to a heat sink 200a by means of a threaded bolt, whereby heat energy transfer from the thermal connector 100g into the heat sink 200a is possible. A further heat pipe is provided with thermal contact to the heat sink 200a for either transferring heat energy from the heat sink 200a to another heat sink, which is not depicted in Figure 13, or for transferring heat energy from another heat source (also not depicted) to the heat sink 200a.

According to a further embodiment, instead of a cone with a circular base and top area, it is also possible to provide a thermal connector with at least one contact surface that at least partly comprises pyramidal shape (or truncated pyramidal shape), i.e. a polygonal base area and triangular side surfaces, and in the case of a truncates pyramid, also a polygonal top surface. This geometry also enables a comparatively large thermally active surface with a rather small footprint (corresponding to the polygonal base area).

The thermal connector 100 according to the embodiments advantageously enables an efficient heat transfer e.g. from an electronic circuit board to the exterior of a card slot where the electronic circuit board is placed or plugged into.

A particularly preferred embodiment comprises a thermal connector 100 with a convex conical contact surface 110, which may be combined with a heat sink comprising a concave conical receptacle ("socket") for receiving the thermal connector 100.

According to an embodiment, the conical shape of the connector 100 or its first contact surface 110, respectively, allows fairly coarse tolerances with respect to placing the thermal connector 100 (i.e., relative to a heat sink and its corresponding contact surface) as well as a relatively large thermally conductive mating surface with respect to the available space on e.g. a pluggable unit 400 or within a card slot S1. Advantageously, according to an embodiment, a flexible heat pipe 140 that runs from the heat dissipating component 300 to the thermal connector 100 accommodates movements which may e.g. be caused by floating. According to a further embodiment, the thermal connector comprises a very good surface finishing that can be easily accomplished by the conical shape. According to a further embodiment, polishing the surfaces and/or usage of thermal grease is probably even reducing the thermal resistance.

According to a further embodiment, the thermal connector 100 is assembled and/or arranged in a manner so that floating in all three spatial axes is possible, e.g. with respect to a device 400 it is assigned to, and via a spring loaded mounting principle (cf. e.g. the mounting unit 150 explained above) there is also sufficient mating force provided. Furthermore, a possibility for "depth-wise" floating (i.e. horizontal movement of the connector 100c of Fig. 9) also accommodates insertion tolerances of associated backplane connectors 402a, 402b in a simple manner.

According to a further embodiment, depending on the cooling needs there can be also several connectors 100 combined on a board 400, also in combination with backplane connectors.

According to a further embodiment, for better heat transfer there can also be an optional screw 112a (Fig. 7) added to the arrangement. The mating force can be significantly increased by the screw 112a and if it is an active jack screw it can even be used for pushing out the pluggable side of the connector if seated to tight (depending on the angle of the cone 110).

According to a further embodiment, the principle of the connector according to the embodiments could even be used for daisy-chaining heat sinks and flexible heat pipes.

The following list gives further advantages of the thermal connector 100 according to the embodiments.
- only small footprint needed compared to large contact surface of conventional systems with merely two-dimensional thermal contact surface
- conical shape of mechanical interface is easy for production (rotational symmetric shape) and can be achieved with a high precision
- conical thermal connector enables mechanical tolerance alignment
- cone surface on pluggable unit side and heat sink side can easily be polished with little surface roughness
- cone surface and angle can easily be optimized for minimum thermal resistance for specific applications
- cone material shall be e.g. copper or other highly heat conductive material for maximum heat transfer and may at the same time be used to establish an electrically conductive connection (e.g. for ground potential or the like)
- tolerance accommodation may be facilitated along x-y-z axes by assembly bracket and flexible heat pipe
- spring loaded contact between connector 100 and heat sink 200 offers simple mounting; this can further be improved by additional screw fixation
- according to an embodiment, the spring can also be replaced by other methods (servo motor, hydraulic pressure, etc.)
- "blind mating" is easily achievable by still allowing coarse tolerances for the cone position (floating arrangement)
- multiple vertical placements of thermal couplers per pluggable unit in combination with electrical or optical connectors (also cf. Fig. 12)
- EMC proof interface to e.g. rear side heat sink, heat spreader or heat exchanger possible

The principle according to the embodiments allows to improve cooling of components, e.g. of pluggable units (cards or circuit boards, but also non-electric devices), and to remove bulky heat sinks from these. According to an embodiment, a fixed heat sink 200 can be used for multiple pluggable units 400, it can be optimized for heat transfer without wasting board space on the units 400, and it can be even be used in combination with liquid cooling, eliminating the need for pluggable liquid media (thermal fluid) connectors. This is a tremendous advantage with respect to reliability and lifetime since there are no rubber O-rings necessary for sealing.

The principle according to the embodiments enables better heat transfer as compared to prior art cooling systems with planar thermal contact surfaces; cost reduction; easy manufacturing; high reliability; robustness; saving of floor space ("footprint") on PCBs (printed circuit boards).

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. Thermal connector (100) for establishing a thermally conductive connection with at least a first element (200), wherein said thermal connector (100) comprises a first contact surface (110) for contacting a portion of said first element (200), wherein said first contact surface (110) at least partly comprises a conical shape.

2. Connector (100) according to claim 1, wherein said connector (100) comprises a basically cylindrical main body (102) and wherein said conical shape of said contact surface (110) extends along an axial direction of said main body (102).

3. Connector (100) according to one of the preceding claims, wherein said connector (100) comprises at least one threaded hole (112).

4. Connector (100) according to one of the preceding claims, wherein said connector (100) comprises at least one further contact surface (120, 130) for establishing a thermally conductive connection with at least one second element (300; 300a, 300b, 300c).

5. Connector (100) according to one of the preceding claims, wherein at least one of said contact surfaces (110, 120, 130) at least partially comprises
a. a surface finish with a surface roughness Ra of about 10 µm or less, and/or
b. a microstructured surface, and/or
c. a polished surface, and/or
d. a thermally conductive material.

6. Connector (100) according to one of the preceding claims, wherein said connector (100) comprises a heat transfer device (140) for establishing a thermally conductive connection with at least one second element (300e).

7. Connector (100) according to claim 6, wherein said heat transfer device (140) comprises at least one heat pipe.

8. Connector (100) according to claim 7, wherein said heat pipe (140) comprises at least one flexible section (140c).

9. Connector (100) according to one of the preceding claims, wherein said connector (100) comprises a mounting unit (150) for detachably attaching said connector (100) to a target system (400).

10. Pluggable electrical device (400) comprising at least one thermal connector (100) according to the preceding claims.

11. Device (400) according to claim 10, wherein said at least one thermal connector (100) is arranged at an edge section of said device (400).

12. Device (400) according to one of the claims 10 to 11, wherein said at least one thermal connector (100) is movably attached to said device (400) or a component (300e, 300f) thereof.

13. Heat distribution device (200; 200a) for establishing'a thermally conductive connection with at least one element (100), particularly with at least one thermal connector (100) according to one of the claims 1 to 9, wherein said heat distribution device (200; 200a) comprises at least one contact surface (206) for contacting said element (100), wherein said at least one contact surface (206) at least partly comprises a conical shape.

14. Heat distribution device (200; 200a) according to claim 13, wherein said device comprises attaching means for detachably attaching said at least one element (100) to said device (200; 200a).
